# FASCICULE DE BREVET EUROPEEN

(11) **EP 1 881 088 B1**
(45) Date de publication et mention de la délivrance du brevet: **13.08.2008**
(21) Numéro de dépôt: 07112039.8
(22) Date de dépôt: 09.07.2007
(51) Int. Cl.: C23C 16/511, B05C 7/02, B05D 7/22

(54) **Dispositif pour le dépôt d'un revêtement sur une face interne d'un récipient**
Vorrichtung zur Abscheidung einer Beschichtung auf der inneren Fläche eines Gefässes
Apparatus for depositing a coating on the internal surface of a container

(30) Priorité: 17.07.2006 FR 0606480
(43) Date de publication de la demande: 23.01.2008
(73) Titulaire: SIDEL PARTICIPATIONS, 76930 Octeville-sur-Mer (FR)
(72) Inventeur: RIUS, Jean-Michel, c/o SIDEL, 76930 OCTEVILLE S/MER (FR); CHOMEL, Nicolas, c/o SIDEL, 76930 OCTEVILLE S/MER (FR); DUCLOS, Yves-Alban, c/o SIDEL, 76930 OCTEVILLE S/MER (FR)
(74) Mandataire: Cabinet Plasseraud

(56) Documents cités:
- EP-A- 1 561 840
- EP-A- 1 619 266
- EP-A1- 1 630 250
- WO-A-02/09891
- WO-A-20/04044039
- WO-A-20/06000539
- WO-A-20/06005837
- WO-A2-20/06000561

## Description

La présente invention porte sur un dispositif pour le dépôt d'un revêtement sur une face interne d'un récipient en matériau thermoplastique, du type dans lequel le dépôt est réalisé à l'aide d'un plasma à basse pression qui est créé à l'intérieur du récipient par excitation d'un gaz précurseur grâce à des ondes électromagnétiques de type micro-ondes, et du type dans lequel le récipient est placé dans une enceinte en matériau conducteur à l'intérieur de laquelle les micro-ondes sont introduites, ledit dispositif comprenant : a) un générateur d'ondes électromagnétiques ; b) un guide d'ondes électromagnétiques pour raccorder le générateur à une fenêtre de la paroi latérale de l'enceinte, permettant de générer au moins un champ central dans cette enceinte c) des moyens d'injection du gaz précurseur, d) des moyens de pompage de l'enceinte et du volume interne du récipient, et e) une enveloppe interne, coaxiale à l'enceinte, sensiblement transparente pour les ondes électromagnétiques, par exemple réalisée en quartz, et définissant une cavité cylindrique dans laquelle est placé le récipient lors de l'excitation du gaz précurseur.

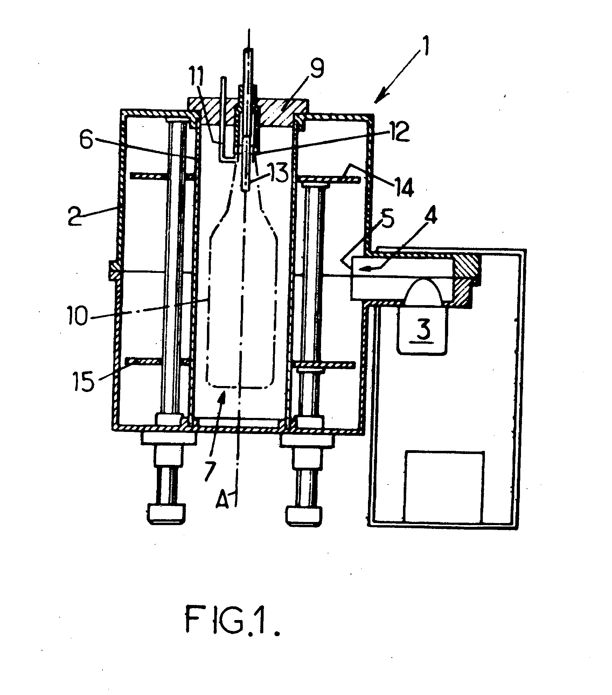

A la figure 1 est illustré schématiquement un dispositif agencé conformément aux dispositions du document FR 2 792 854 pour le traitement de récipients un par un et qui se présente sous forme d'un poste 1 de traitement propre à assurer le dépôt par plasma à basse pression d'un revêtement sur la face interne d'un récipient en matériau thermoplastique, tel que préférentiellement, mais non exclusivement, une bouteille en polyéthylène téréphtalate (PET), le revêtement à former pouvant être constitué d'un matériau à base de carbone hydrogéné ou encore de silice.

Succinctement, le poste 1 comporte une cavité 2 extérieure en matériau conducteur, notamment métallique. La cavité 2 est cylindrique d'axe A et elle est dimensionnée pour favoriser un mode particulier de couplage d'un champ électromagnétique de type micro-ondes. Un générateur 3, qui est agencé à l'extérieur de la cavité 2, est susceptible de délivrer un champ électromagnétique dans le domaine des micro-ondes, dont la fréquence peut être typiquement de 2,45 GHz ou 915 MHz, le générateur 3 étant du type générateur d'ondes électromagnétiques UHF (Ultra Haute Fréquences). Le rayonnement électromagnétique délivré par le générateur 3 est amené jusqu'à la cavité 2 par un guide d'ondes 4 en forme de tunnel d'étendue radiale qui débouche au travers d'une fenêtre 5 rectangulaire aménagée dans la cavité 2, approximativement à mi-hauteur de celle-ci. La forme et les dimensions du guide d'ondes 4 sont elles aussi adaptées pour permettre un couplage favorable du champ de micro-ondes dans la cavité 2.

A l'intérieur de la cavité 2 est disposée une enveloppe 6 qui est coaxiale à la cavité 2, qui est sensiblement transparente pour les micro-ondes, et qui délimite, à l'intérieur de la cavité 2, une enceinte cylindrique 7 coaxiale à la cavité 2. En pratique l'enveloppe 6 est par exemple réalisée en quartz. L'enceinte 7 est fermée inférieurement par une paroi transversale inférieure de la cavité 2, et supérieurement par un couvercle 9 destiné à une fermeture étanche de telle sorte que le vide puisse être établi dans l'enceinte 7. Le récipient 10 à traiter est disposé de manière sensiblement coaxiale à la cavité 2 et à l'enceinte 7.

Dans le mode de réalisation considéré, pour permettre l'introduction du récipient 10 à traiter à l'intérieur de l'enceinte 7, le couvercle 9 est amovible. Mais on pourrait aussi prévoir un couvercle fixe et un fond mobile pratiqué dans la paroi transversale inférieure de la cavité 2 pour permettre l'amenée ou le retrait du récipient par le bas. Sur le couvercle 9, il est prévu des moyens 11 pour supporter le récipient 10 par son col 12, des moyens pour créer différents niveaux de vide dans l'enceinte 7, ainsi que des moyens pour injecter à l'intérieur du récipient 10 un fluide réactionnel qui contient au moins un précurseur du matériau que l'on souhaite déposer sur la paroi interne du récipient, lesdits moyens d'injection comprenant un tube 13 d'injection s'étendant partiellement à l'intérieur du récipient.

Le dispositif comporte aussi des plateaux 14, 15 annulaires respectivement supérieur et inférieur d'axe A qui sont disposés dans la cavité 2, autour de l'enveloppe 6. Les deux plateaux 14, 15 sont décalés axialement l'un par rapport à l'autre de manière à être disposés axialement de part et d'autre de la fenêtre 5 par laquelle le guide d'ondes 4 débouche dans la cavité 2. Toutefois, leurs positions axiales respectives peuvent varier en fonction de la forme du récipient 10 à traiter. Les plateaux 14, 15, qui sont réalisés en matériau électriquement conducteur, sont destinés à former des courts-circuits pour le champ électromagnétique formé dans la cavité 2, de manière à confiner axialement le champ pour obtenir un maximum de l'intensité au niveau de la zone effective de traitement.

Toutefois, le processus de revêtement par plasma dans un dispositif tel que décrit ci-dessus, bien que fonctionnant correctement, présente certains aléas pouvant résulter en un dépôt du revêtement non homogène.

En effet, il est souvent difficile de contrôler avec précision l'amorçage du plasma ainsi que sa stabilité, un plasma instable entraînant des risques de formation d'un dépôt non homogène sur la paroi interne du récipient.

Actuellement, pour vérifier si un plasma est stable ou non, on mesure l'intensité lumineuse dans le récipient à l'aide d'un capteur de luminosité. Si une instabilité lumineuse est détectée, on considère alors que le plasma a été instable, et donc, arbitrairement, que le dépôt n'a pas été réalisé correctement. Le récipient est alors rejeté de la ligne de production.

Ainsi, dans le cas où le dépôt du revêtement a lieu à l'aide d'une installation permettant le revêtement interne de plusieurs milliers de récipients à l'heure, il convient de réduire autant que possible le pourcentage de récipients non correctement revêtus représentant des déchets pouvant atteindre plusieurs centaines de récipients par jour. Actuellement, le pourcentage de récipients rejetés, car potentiellement non correctement revêtus, avoisine les 0,5%. Il serait particulièrement intéressant de diminuer ce pourcentage afin de réduire les déchets générés par une telle installation, et de réduire par voie de conséquence la perte de matière première correspondante.

Par ailleurs, lors de l'émission des ondes électromagnétiques dans la cavité, les ondes sont réfléchies par le tube d'injection et ont tendance à remonter le long de celui-ci vers le centre du dispositif de traitement, entraînant des risques de dysfonctionnement du dispositif et une perte de l'énergie électromagnétique utilisable dans la cavité de traitement, d'où des risques d'instabilité du plasma.

La présente invention porte donc sur un dispositif pour le revêtement sur une paroi interne d'un récipient permettant aussi bien une distribution optimale des gaz précurseurs dans le récipient pour former un revêtement uniforme que le blocage de l'onde électromagnétique en remontée le long du tube d'injection.

Ainsi, la présente invention porte sur un dispositif pour le dépôt d'un revêtement sur une paroi interne d'un récipient permettant d'amorcer et de faciliter la formation du plasma lors de l'émission des micro-ondes ainsi que d'éviter les pertes de l'énergie électromagnétique utilisable dans la cavité de traitement, résultant en la formation d'un plasma plus stable et en la réalisation d'une ligne de production pour le revêtement interne de récipients avec un pourcentage de rejets de récipients nettement inférieur à 0,5%, et tendant avantageusement vers un pourcentage de récipients rejetés nul.

Pour ce faire, la présente invention a pour objet un dispositif pour le dépôt d'un revêtement sur une face interne d'un récipient en matériau thermoplastique, du type dans lequel le dépôt est réalisé à l'aide d'un plasma à basse pression qui est créé à l'intérieur du récipient par excitation d'un gaz précurseur grâce à des ondes électromagnétiques de type micro-ondes UHF, et du type dans lequel le récipient est placé dans une cavité en matériau conducteur à l'intérieur de laquelle les micro-ondes sont introduites, ledit dispositif comprenant un générateur d'ondes électromagnétiques UHF ; un guide d'ondes électromagnétiques pour raccorder le générateur à une fenêtre de la paroi latérale de la cavité, permettant de générer au moins un champ central dans la cavité ; des moyens d'injection du gaz précurseur comprenant un tube d'injection s'étendant partiellement dans le récipient ; des moyens de pompage de la cavité et du volume interne du récipient, et une enveloppe interne, coaxiale à la cavité, sensiblement transparente pour les ondes électromagnétiques, par exemple réalisée en quartz, et définissant une enceinte cylindrique dans laquelle est placé le récipient lors de l'excitation du gaz précurseur, caractérisé en ce que le tube d'injection plonge dans le récipient d'une longueur comprise entre le quart et la moitié de la hauteur totale du récipient considérée entre le buvant et le fond du récipient, la longueur du tube d'injection constituant une antenne longitudinale propre à capter l'onde électromagnétique UHF générée par ledit générateur, en ce qu'un court-circuit micro-ondes sous la forme d'une plaque est prévu sur le tube d'injection de manière telle que la face côté cavité de ladite plaque définit un point d'amplitude nulle de l'onde électromagnétique qui se propage le long du tube d'injection, la longueur entre le court-circuit et l'extrémité libre du tube d'injection correspondant à un nombre impair de quarts de longueurs d'onde, afin d'obtenir une amplitude maximale, c'est-à-dire un ventre de l'onde électromagnétique, au niveau de l'extrémité libre du tube d'injection.

De cette façon, du fait que l'extrémité du tube d'injection correspond à un ventre de l'onde électromagnétique qui s'est propagée sur ce tube, et du fait du placement de cette extrémité entre la moitié et le quart de la hauteur totale du récipient, l'amorçage d'un plasma stable est facilité car l'extrémité de l'injecteur correspond à un point d'intensité électromagnétique maximale pour une longueur d'onde donnée et avec une répartition homogène des gaz dans le récipient.

Afin que l'onde électromagnétique soit à une amplitude nulle et arrête au moins partiellement sa propagation le long du tube d'injection, le court-circuit est une plaque circulaire radiale traversée en son centre par le tube d'injection. Le courant de surface le long du tube d'injection est alors nul à la surface du côté de la plaque circulaire dirigée vers la cavité.

De manière à améliorer l'effet de blocage de la propagation de l'onde électromagnétique le long du tube d'injection, une jupe annulaire, coaxiale au tube d'injection et dirigée vers la cavité, prend appui sur la plaque circulaire radiale.

Avantageusement, selon une première forme de réalisation du court-circuit, la jupe annulaire prend appui sur le rebord externe de la plaque circulaire.

Afin d'isoler électriquement le tube d'injection du reste du dispositif, la plaque circulaire et le tube d'injection ne doivent pas toucher le reste de l'enceinte, et peuvent être noyés dans un bouchon diélectrique traversé axialement par le tube d'injection.

De manière avantageuse, selon une seconde forme de réalisation d'un court-circuit, la plaque circulaire présente un orifice central de diamètre supérieur au diamètre du tube d'injection et la jupe annulaire prend appui sur le rebord interne de la plaque.

Afin de bloquer la propagation du champ électromagnétique le long de l'injecteur en remontée en aval de la plaque circulaire, la hauteur de la face interne de la jupe annulaire est sensiblement égale au quart de la longueur d'onde de l'onde émise par le générateur et circulant dans le milieu diélectrique dans lequel se trouvent la plaque circulaire et la jupe. Par ailleurs, l'extrémité libre de la jupe annulaire correspond alors à un ventre de l'onde, ce qui correspond à une tension maximale et une intensité minimale, d'où des pertes par effet Joule réduites. Il est ainsi évité d'avoir un échauffement non maîtrisé de l'extrémité libre de la jupe annulaire du fait des pertes par effet Joule minimales à cette extrémité.

Afin de maîtriser le champ électromagnétique le long du tube d'injection, le court-circuit est prévu dans un espace annulaire entre un élément cylindrique, appelé chemise, et le tube d'injection.

Afin de permettre le pompage du volume interne du récipient, l'extrémité de l'élément cylindrique prend appui de manière étanche sur le buvant du récipient.

Afin de stabiliser le plasma lors de la génération de l'onde électromagnétique et lors du dépôt du revêtement sur la paroi interne du récipient et, ainsi, afin de diminuer les risques d'un dépôt d'un revêtement non homogène sur la paroi interne du récipient, le dispositif selon l'invention comprend des moyens générateurs de signal haute tension couplés au tube d'injection et aptes à envoyer un signal haute tension sinusoïdal sur le tube d'injection.

Selon un mode de réalisation préférentiel permettant de stabiliser au mieux le plasma généré dans le récipient, le signal haute tension sinusoïdal a une tension comprise entre 500 et 3000V.

Avantageusement, le signal haute tension sinusoïdal consiste en une pluralité de cycles de signaux sinusoïdaux amortis.

De manière avantageuse, la fréquence porteuse dudit signal est comprise entre 1 et 50 kHz.

Selon un mode de réalisation avantageux, la fréquence d'enveloppe dudit signal est comprise entre 100 et 10000 Hz.

De manière avantageuse, ladite fréquence d'enveloppe est comprise entre 500 et 2000 Hz.

Avantageusement la valeur crête du signal haute tension en fin d'un desdits cycles est amortie entre 0 et 60% de la valeur crête du premier pic de ce cycle.

De manière avantageuse, la valeur crête du signal haute tension en fin d'un desdits cycles est amortie entre 20 et 40 % de la valeur crête du premier pic de ce cycle.

Afin d'améliorer le blocage de la propagation de l'onde électromagnétique le long du tube d'injection, le diamètre de la plaque circulaire est au moins supérieur au double du diamètre du tube d'injection.

Afin de réduire la quantité d'énergie électromagnétique qui n'est pas bloquée par la plaque circulaire du court- circuit prévu selon l'invention, une seconde plaque circulaire est fixée radialement sur le tube d'injection en amont de la plaque circulaire.

Avantageusement, la distance entre la plaque circulaire et ladite seconde plaque circulaire correspond à un multiple de la demi-longueur d'onde de l'onde électromagnétique générée par ledit générateur.

L'invention sera mieux comprise à la lecture de la description détaillée qui suit de certains modes de réalisation préférés donnés uniquement à titre d'exemples non limitatifs. Dans cette description, on se réfère aux dessins annexés sur lesquels :
- la figure 1 est une vue schématique de côté, en coupe, d'un dispositif selon l'art antérieur pour le traitement de récipients un par un ;
- la figure 2 est une vue schématique de côté d'un dispositif pour le traitement de récipients un par un selon l'invention
- la figure 3 est une vue en coupe schématique d'un court-circuit prévu sur l'injecteur du dispositif selon l'invention ;
- la figure 4 est une forme de réalisation alternative d'un court-circuit prévu sur l'injecteur selon l'invention ;
- la figure 5 est une vue en coupe frontale schématique d'une forme de réalisation alternative du dispositif selon l'invention ;
- la figure 6 est une vue en coupe schématique d'une autre forme de réalisation du dispositif selon l'invention ;

Comme cela a été précédemment décrit, la figure 1 est une vue schématique d'un dispositif pour le dépôt d'un revêtement sur une face interne d'un récipient 10 en matériau thermoplastique, du type dans lequel le dépôt est réalisé à l'aide d'un plasma à basse pression qui est créé à l'intérieur du récipient par excitation d'un gaz précurseur grâce à des ondes électromagnétiques UHF de type micro-ondes, et du type dans lequel le récipient 10 est placé dans une cavité 2 en matériau conducteur à l'intérieur de laquelle les micro-ondes sont introduites, ledit dispositif comprenant un générateur 3 d'ondes électromagnétiques UHF ; un guide 4 d'ondes électromagnétiques pour raccorder ledit générateur 3 à une fenêtre 5 de la paroi latérale de la cavité 2 ; des moyens d'injection du gaz précurseur ; des moyens de pompage de la cavité 2 et du volume interne du récipient 10, et une enveloppe interne 6, coaxiale à la cavité 2 et à au moins un champ central engendré dans la cavité 2, sensiblement transparente pour les ondes électromagnétiques, par exemple réalisée en quartz, et définissant une enceinte 7 cylindrique dans laquelle est placé le récipient 10 lors de l'excitation du gaz précurseur.

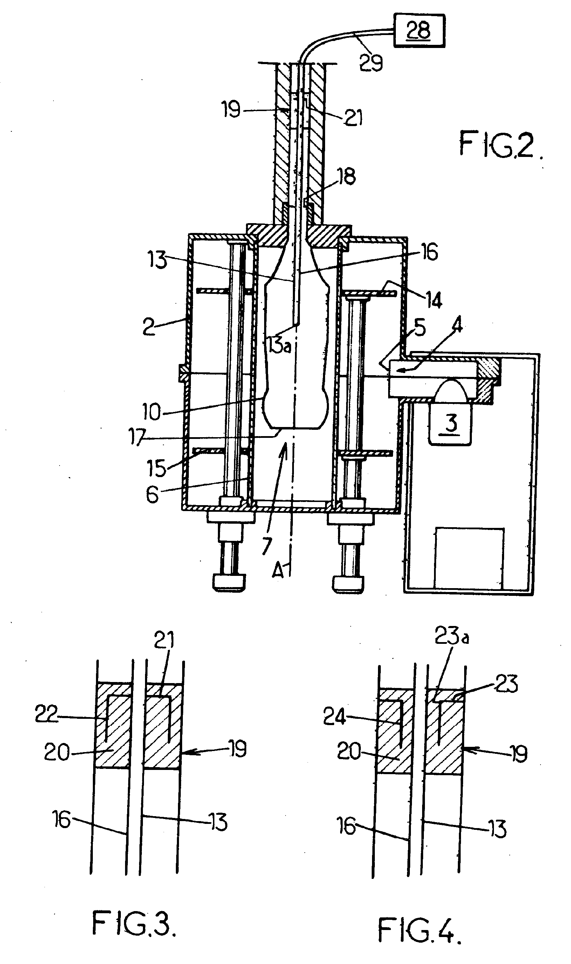

La figure 2 est une vue en coupe schématique d'une forme de réalisation d'un dispositif 1 de traitement de récipients 10 un par un pour le dépôt d'un revêtement sur la face interne du récipient 10.

Selon ce mode de réalisation, les moyens d'injection du gaz précurseur dans le volume interne du récipient 10 se présentent sous la forme d'un tube 13 d'injection, constituant une antenne 16 longitudinale propre à capter une onde électromagnétique UHF générée par le générateur 3, et placée sensiblement sur l'axe central A défini par le récipient 10, la cavité 2 et l'enveloppe 6. La deuxième fonction de cette antenne 16 est de propager le signal haute tension émis par des moyens 28 générateurs d'un signal haute tension, comme cela sera explicité ultérieurement.

Dans la suite de la description, la notion de tube 13 d' injection désigne également la notion d'antenne 16, ces deux éléments étant identiques.

Le récipient 10 se présente avantageusement sous la forme d'une bouteille avec un col 12, un fond 17 et un buvant 18, le principe de l'invention s'appliquant à tout type de récipient avec un fond et un buvant, c'est-à-dire avec une extrémité fermée et une extrémité ouverte.

Afin de permettre un bon écoulement des gaz injectés dans le volume interne du récipient 10 et que les gaz soient distribués de manière homogène dans ce volume interne, l'extrémité libre 13a du tube 13 d'injection est plongée dans le récipient 10 sur une longueur comprise entre le quart et la moitié de la hauteur totale du récipient 10, à savoir sur une longueur comprise entre le quart et la moitié de la distance entre le buvant 18 et le fond 17 du récipient 10. Ainsi, du fait de la meilleure répartition des gaz injectés dans le volume interne du récipient 10, il est obtenu un plasma plus stable lors de l'excitation électromagnétique.

Un court-circuit 19 UHF est prévu, avantageusement en contact de conduction électrique, sur le tube 13 d'injection dans une partie de celui-ci restant à l'extérieur du récipient 10, de manière à court-circuiter la propagation de l'onde électromagnétique le long du tube 13 d'injection.

Selon une forme de réalisation telle qu'illustrée à la figure 3, le court-circuit 19 se présente sous la forme d'un bouchon 20, préférentiellement en matériau diélectrique, par exemple du poly-ether-ether-cetone, traversé axialement par le tube 13 d'injection et dans lequel est noyée une plaque 21, avantageusement circulaire, radiale conductrice, préférentiellement métallique, traversée en son centre par le tube 13 d'injection, le diamètre de la plaque circulaire 21 étant inférieur au diamètre du bouchon 20.

Alternativement, le court-circuit 19 se compose uniquement de la plaque 21 circulaire.

Dans tous les cas, l'onde électromagnétique se propageant le long du tube d'injection 13 est à une amplitude nulle au niveau du côté de la plaque 21 circulaire dirigée vers la cavité 2.

Une jupe annulaire 22, coaxiale au tube 13, prend appui sur la plaque 21 circulaire et est dirigée vers la cavité 2.

Selon une forme de réalisation, la jupe 22 annulaire prend appui sur le rebord externe de la plaque 21 circulaire.

Selon une autre forme de réalisation du court-circuit 19 telle qu'illustrée sur la figure 4, il est prévu un bouchon diélectrique 20 traversé en son centre par le tube 13 d'injection avec une plaque 23 circulaire radiale noyée dans le bouchon 20, la plaque 23 circulaire comportant un orifice 23a central de diamètre supérieur au diamètre du tube 13 d'injection, une jupe 24 annulaire prenant alors appui sur le rebord interne de la plaque 23 circulaire, la jupe annulaire 24 étant dirigée vers la cavité 2 et coaxiale au tube 13 d'injection. La plaque 23 circulaire a alors son rebord périphérique externe confondu avec le pourtour extérieur cylindrique du bouchon 20.

Avantageusement, la hauteur de la face interne de la jupe 22, 24 annulaire est sensiblement égale au quart de la longueur d'onde de l'onde électromagnétique émise par le générateur 3 qui s'est propagée le long de l'antenne 16, cette longueur d'onde étant dépendante du milieu diélectrique dans lequel se trouve la plaque 21, 23 circulaire et la jupe 22, 24 annulaire.

Autrement dit, afin de bloquer l'onde électromagnétique en remontée en aval de la plaque 21, 23 circulaire, la hauteur de la face interne de la jupe 22, 24 annulaire est sensiblement égale au quart de la longueur d'onde de l'onde émise par le générateur et circulant dans le milieu dans lequel se trouvent la plaque 21, 23 circulaire et la jupe 22, 24. De plus, l'extrémité libre de la jupe 22, 24 annulaire correspond alors à un ventre de l'onde électromagnétique, ce qui correspond à une tension maximale et une intensité minimale, d'où des pertes par effet Joule réduites. Il est ainsi évité d'avoir un échauffement non maîtrisé de l'extrémité libre de la jupe 22, 24 annulaire du fait des pertes par effet Joule minimales à cette extrémité.

Ainsi, si la plaque circulaire 21, 23 est noyée dans un bouchon 20 en diélectrique, la hauteur de la jupe annulaire est égale au quart de la longueur d'onde de l'onde électromagnétique circulant dans un tel milieu diélectrique.

De manière alternative, si la plaque circulaire 21 n'est pas noyée dans un bouchon 20 de diélectrique mais est uniquement fixée radialement sur l'antenne 16 dans le vide, alors la hauteur de la face interne de la jupe annulaire 22 est égale au quart de la longueur d'onde de l'onde électromagnétique circulant dans le vide.

De manière plus générale, la hauteur de la face interne de la jupe annulaire est égale au quart de la longueur d'onde de l'onde électromagnétique circulant dans le milieu dans lequel sont insérées la plaque circulaire et la jupe, par exemple le vide ou un diélectrique. Le court-circuit forme alors un piège quart d'onde.

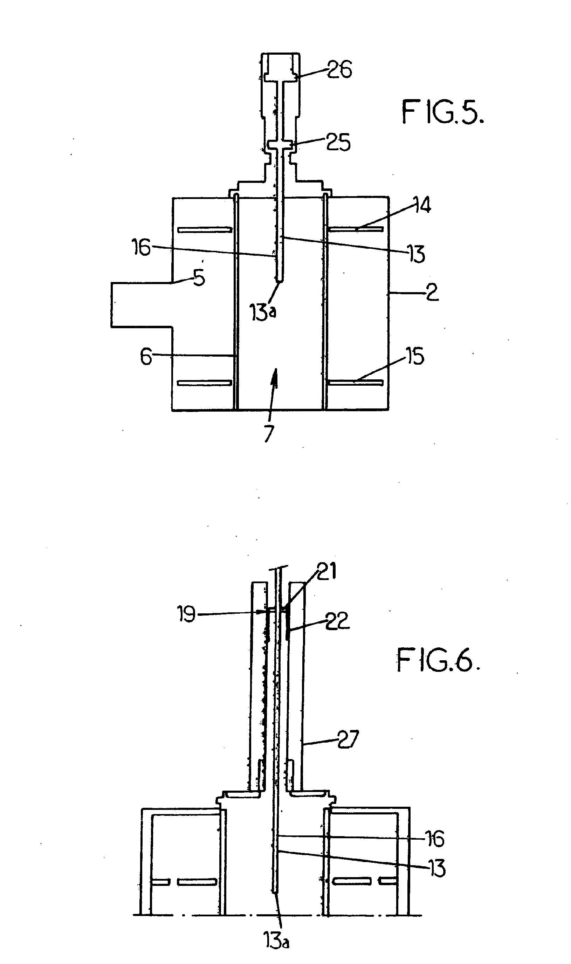

Afin de limiter la remontée des ondes électromagnétiques le long de l'antenne 16, il est également possible, selon une troisième forme de réalisation de l'invention illustrée à la figure 5, de fixer une paire de plaques circulaires 25, 26 le long du tube 13 d'injection.

En effet, en présence d'une seule plaque circulaire, l'énergie électromagnétique n'est pas totalement bloquée et court-circuitée le long du tube 13 d'injection et il est préférable d'ajouter une seconde plaque circulaire 26 au dessus de la première plaque 25 afin de bloquer la quasi-totalité de l'énergie électromagnétique remontant le long du tube 13 d'injection. Ainsi, il est prévu une première plaque aval 25 située au-dessus du buvant 18 du récipient 10, selon les conditions décrites précédemment, et une seconde plaque amont 26 placée au-dessus de la plaque aval 25.

De manière préférentielle, la distance entre la plaque aval 25 et la seconde plaque amont 26 correspond à un multiple de demi-longueurs d'ondes de l'onde électromagnétique émise par le générateur 3 d'ondes électromagnétiques.

De manière avantageuse, dans tous les modes de réalisation décrits, le diamètre de la plaque circulaire 21, 23, 25, 26 est au moins supérieur au double du diamètre du tube 13 d'injection, et préférentiellement au moins supérieur au quadruple du diamètre du tube 13 d'injection.

L'ajout d'une jupe annulaire 22, 24 sur la plaque 21, 23 circulaire permet d'augmenter la quantité d'énergie électromagnétique bloquée en remontée le long du tube 13 d'injection.

Ainsi, et comme représenté sur la figure 6, la présence d'une seule plaque circulaire 21 avec une jupe annulaire 22, comme cela a été précédemment décrit en rapport avec la figure 3, permet de bloquer la quasi-totalité de l'énergie électromagnétique en remontée le long de l'antenne 16.

Avantageusement, le tube 13 d'injection traverse une chemise 27 dont l'extrémité permet de former une liaison étanche avec le buvant 18 du récipient 10, le diamètre de la plaque circulaire 21 ou de la jupe annulaire 22 étant très proche mais légèrement inférieur au diamètre de l'orifice intérieur de la chemise 27.

Afin de maîtriser l'onde électromagnétique le long du tube 13 d'injection, le court-circuit 19 est prévu dans un espace annulaire entre un élément cylindrique appartenant au couvercle 9, appelé chemise 27, et le tube 13 d'injection.

Le court-circuit 19, et plus précisément la face côté cavité de la plaque circulaire 21, 23, 25, définit un point d'amplitude nulle de l'onde électromagnétique qui se propage le long du tube 13. La longueur entre le court-circuit 19 et l'extrémité 13a correspond à un nombre impair de quarts de longueurs d'onde, afin d'obtenir une amplitude maximale, c'est-à-dire un ventre, au niveau de l'extrémité libre 13a du tube 13 d'injection.

De manière supplémentaire, un signal haute tension sinusoïdal est envoyé sur le tube 13 d'injection à l'aide de moyens 28 générateurs de signal à haute tension, de type connu en soi, et couplés à l'aide d'un câble haute tension 29 au tube 13 d'injection en amont du court-circuit 19 ou de la seconde plaque circulaire amont 26.

Préférentiellement, la fréquence du signal haute tension est comprise entre 1 et 50 kHz, et de manière préférentielle est proche de 7200 kHz. Dans le cas de la génération d'un signal haute tension amorti, il s'agit alors de la fréquence porteuse.

Le signal est envoyé de manière permanente ou partielle ou conditionnelle (par exemple uniquement si un certain seuil de luminosité est détecté dans l'enveloppe interne 6) durant le cycle de réalisation du plasma, c'est-à-dire pendant la phase de décharge électromagnétique et la phase de dépôt du revêtement sur la paroi interne du récipient 10.

Avantageusement, le signal haute tension est amorti et consiste donc en la génération d'une pluralité de cycles de signaux sinusoïdaux amortis paramétrables dont la fréquence d'enveloppe, c'est-à-dire la fréquence des cycles sinusoïdaux amortis, est comprise entre 100 et 10000 Hz, préférentiellement entre 500 et 6000 Hz, de manière encore plus préférentielle entre 500 et 2000 Hz, et de manière encore plus préférentielle est de 1000 Hz.

Le signal haute tension sinusoïdal a une tension comprise entre 500 et 3000V, préférentiellement de 1000 V.

Préférentiellement, la valeur crête du signal haute tension en fin d'un desdits cycles est amortie entre 0 et 60% de la valeur crête du premier pic de ce même cycle, préférentiellement entre 20 et 40% de la valeur crête du premier pic de ce cycle, et de manière encore plus préférentielle de 30% au maximum.

Avantageusement, le rapport fréquentiel entre la fréquence porteuse et la fréquence d'enveloppe doit être supérieur à 2, et de manière encore plus préférentielle doit être supérieur à 7.

Il a été de manière surprenante découvert que la génération et/ou le maintien d'un tel signal haute tension sinusoïdal permet d'améliorer la stabilité du plasma sur une ligne de production et donc de diminuer le nombre d'instabilités lumineuses détectées par le capteur de luminosité et donc de diminuer le nombre de récipients rejetés, car présentant potentiellement un revêtement non homogène.

Afin d'isoler électriquement le tube d'injection 13 du reste du dispositif, la plaque circulaire 21, 23, 25 et le tube 13 d'injection ne doivent pas toucher le reste de l'enceinte, et peuvent être noyés dans un bouchon diélectrique traversé axialement par le tube 13 d'injection. De cette manière, le tube 13 d'injection est isolé électriquement afin d'éviter tout arc électrique ou courant de fuite de la part du tube 13 d'injection à l'exception de l'extrémité libre 13a du tube 13 d'injection ou sur un autre point prédéterminé lors de la conception par un design spécifique sur le tube 13 d'injection, par exemple en rajoutant une pointe radiale sur l'extrémité 13a libre du tube 13 d'injection. Il est en effet souhaité d'obtenir une concentration maximale d'électrons à un point donné pour alors faciliter l'amorçage du plasma et donc éviter tous les courants de fuite, d' où la nécessite d' isoler électriquement le tube 13 d'injection et d'ajouter éventuellement une pointe radiale sur l'extrémité libre du tube d'injection.

## Revendications

1. Dispositif pour le dépôt d'un revêtement sur une face interne d'un récipient (10) en matériau thermoplastique, du type dans lequel le dépôt est réalisé à l'aide d'un plasma à basse pression qui est créé à l'intérieur du récipient (10) par excitation d'un gaz précurseur grâce à des ondes électromagnétiques de type micro-ondes UHF, et du type dans lequel le récipient (10) est placé dans une cavité (2) en matériau conducteur à l'intérieur de laquelle les micro-ondes sont introduites, ledit dispositif comprenant :
- un générateur (3) d'ondes électromagnétiques UHF ;
- un guide (4) d'ondes électromagnétiques pour raccorder ledit générateur (3) à une fenêtre (5) de la paroi latérale de la cavité (2), permettant de générer au moins un champ central dans ladite cavité (2) ;
- des moyens d'injection du gaz précurseur comprenant un tube (13) d'injection s'étendant partiellement dans le récipient (10);
- des moyens de pompage de la cavité (2) et du volume interne du récipient (10), et
- une enveloppe interne (6), coaxiale à la cavité (2), sensiblement transparente pour les ondes électromagnétiques, par exemple réalisée en quartz, et définissant une enceinte (7) dans laquelle est placé le récipient (10) lors de l'excitation du gaz précurseur,
**caractérisé en ce que** le tube (13) d'injection plonge dans le récipient (10) d'une longueur comprise entre le quart et la moitié de la hauteur totale du récipient (10) considérée entre le buvant (18) et le fond (17) du récipient (10), ladite longueur du tube (13) d'injection constituant une antenne (16) longitudinale propre à capter l'onde électromagnétique UHF générée par ledit générateur (3), **en ce qu'**un court-circuit (19) UHF sous la forme d'une plaque (21, 23, 25) est prévu sur le tube (13) d'injection de manière telle que la face côté cavité de ladite plaque (21, 23, 25) définit un point d'amplitude nulle de l'onde électromagnétique qui se propage le long dudit tube (13) d'injection, la longueur entre ledit court-circuit (19) et l'extrémité libre (13a) dudit tube (13) d'injection correspondant à un nombre impair de quarts de longueurs d'onde, afin d'obtenir une amplitude maximale, c'est-à-dire un ventre, au niveau de l'extrémité libre (13a) du tube (13) d'injection.

2. Dispositif selon la revendication 1, **caractérisé en ce que** le court-circuit (19) est une plaque circulaire (21, 23, 25, 26) radiale traversée en son centre par le tube (13) d'injection.

3. Dispositif selon la revendication 2, **caractérisé en ce qu'**une jupe annulaire (22, 24), coaxiale au tube (13) d'injection et dirigée vers la cavité (2), prend appui sur la plaque circulaire (21, 23) radiale.

4. Dispositif selon la revendication 3, **caractérisé en ce que** la jupe annulaire (22, 24) prend appui sur le rebord externe de ladite plaque (21, 23).

5. Dispositif selon l'une quelconque des revendications 2 à 4, **caractérisé en ce que** la plaque circulaire (21, 23) est noyée dans un bouchon (20) diélectrique traversé axialement par le tube (13) d'injection.

6. Dispositif selon l'une quelconque des revendications 1 à 3 et 5, **caractérisé en ce que** ladite plaque circulaire (23) présente un orifice central (23a) de diamètre supérieur au diamètre du tube (13) d'injection et **en ce que** ladite jupe annulaire (22, 24) prend appui sur le rebord interne de ladite plaque (23).

7. Dispositif selon l'une quelconque des revendications 5 ou 6, **caractérisé en ce que** la hauteur de la face interne de la jupe annulaire (22, 24) est sensiblement égale au quart de la longueur d'onde de l'onde émise par le générateur (3) et circulant dans le milieu dans lequel se trouve ladite plaque circulaire (21, 23) et la jupe.

8. Dispositif selon l'une quelconque des revendications 1 à 7, **caractérisé en ce que** le court-circuit (19) est prévu dans un espace annulaire entre un élément cylindrique (27) et le tube (13) d'injection.

9. Dispositif selon la revendication 8, **caractérisé en ce que** l'extrémité de l'élément cylindrique (27) prend appui de manière étanche sur le buvant (18) du récipient (10).

10. Dispositif selon l'une quelconque des revendications 1 à 9, **caractérisé en ce qu'**il comprend des moyens (28) générateurs de signal haute tension couplés au tube (13) d'injection et aptes à envoyer un signal haute tension sinusoïdal sur le tube (13) d'injection.

11. Dispositif selon la .revendication précédente 10, **caractérisé en ce que** le signal haute tension sinusoïdal a une tension comprise entre 500 et 3000V.

12. Dispositif selon l'une des revendications précédentes 10 ou 11, **caractérisé en ce que** ledit signal haute tension sinusoïdal consiste en une pluralité de cycles de signaux sinusoïdaux amortis.

13. Dispositif selon l'une quelconque des revendications précédentes 10 à 12, **caractérisé en ce que** la fréquence porteuse dudit signal est comprise entre 1 et 50 kHz.

14. Dispositif selon l'une quelconque des revendications 12 ou 13, **caractérisé en ce que** la fréquence d'enveloppe dudit signal est comprise entre 100 et 10000 Hz.

15. Dispositif selon la revendication précédente 14, **caractérisé en ce que** ladite fréquence d'enveloppe est comprise entre 500 et 2000 Hz.

16. Dispositif selon l'une quelconque des revendications 12 à 15, **caractérisé en ce que** la valeur crête du signal haute tension en fin d'un desdits cycles est amortie entre 0 et 60% de la valeur crête du premier pic de ce cycle.

17. Dispositif selon la revendication précédente 16, **caractérisé en ce que** la valeur crête du signal haute tension en fin d'un desdits cycles est amortie entre 20 et 40 % de la valeur crête du premier pic de ce cycle.

18. Dispositif selon l'une quelconque des revendications 1 à 17, **caractérisé en ce que** le diamètre de la plaque circulaire (21, 23, 25, 26) est au moins supérieur au double du diamètre du tube (13) d'injection.

19. Dispositif selon l'une quelconque des revendications 1 à 18, **caractérisé en ce qu'**une seconde plaque circulaire (26) est fixée radialement sur le tube (13) d'injection en amont de la plaque circulaire (25).

20. Dispositif selon la revendication précédente 19, **caractérisé en ce que** la distance entre la plaque circulaire (25) et ladite seconde plaque circulaire correspond à un multiple de la demi-longueur d'onde de l'onde électromagnétique générée par ledit générateur (3).

## Claims

1. A device for depositing a coating on an internal surface of a container (10) made of a thermoplastic, of the type in which the deposition is carried out by means of a low-pressure plasma which is created inside the container (10) by excitation of a precursor gas by electromagnetic waves of UHF microwave type, and of the type in which the container (10) is placed inside a cavity (2) made of conducting material into which the microwaves are introduced, said device comprising:
- a UHF electromagnetic wave generator (3);
- an electromagnetic waveguide (4) for connecting said generator (3) to a window (5) in the side wall of the cavity (2), allowing at least one central field to be generated in said cavity (2);
- means for injecting the precursor gas comprising an injection tube (13) extending partly into the container (10);
- means for pumping down the cavity (2) and the internal volume of the container (10); and
- an internal envelope (6), coaxial with the cavity (2), substantially transparent to the electromagnetic waves, for example made of quartz, and defining a chamber (7) in which the container (10) is placed during excitation of the precursor gas,
**characterized in that** the injection tube (13) dips into the container (10) by a length of between one quarter and one half of the total height of the container (10) considered between the mouth (18) and the bottom (17) of the container (10), said length of the injection tube (13) constituting a longitudinal antenna (16) adapted for picking up the UHF electromagnetic wave generated by said generator (3), **in that** a UHF short-circuit (19) in the form of a plate (21, 23, 25) is provided on the injection tube (13) in such a way that the face of said plate (21, 23, 25) facing the cavity defines a point of zero amplitude of the electromagnetic wave that propagates along said injection tube (13), the length between said short-circuit (19) and the free end (13a) of said injection tube (13) corresponding to an odd number of quarter-wavelengths so as to obtain a maximum amplitude, that is to say an antinode, at the free end (13a) of the injection tube (13).

2. The device as claimed in claim 1, **characterized in that** the short-circuit (19) is a circular radial plate (21, 23, 25, 26) through the centre of which the injection tube (13) passes.

3. The device as claimed in claim 2, **characterized in that** an annular skirt (22, 24), coaxial with the injection tube (13) and directed toward the cavity (2), bears on the circular radial plate (21, 23).

4. The device as claimed in claim 3, **characterized in that** the annular skirt (22, 24) bears on the external rim of said plate (21, 23).

5. The device as claimed in any one of claims 2 to 4, **characterized in that** the circular plate (21, 23) is embedded in a dielectric plug (20) through which the injection tube (13) passes axially.

6. The device as claimed in any one of claims 1 to 3 and 5, **characterized in that** said circular plate (23) has a central orifice (23a) having a larger diameter than the diameter of the injection tube (13) and **in that** said annular skirt (22, 24) bears on the internal rim of said plate (23).

7. The device as claimed in any one of claims 5 or 6, **characterized in that** the height of the internal face of the annular skirt (22, 24) is subsatntially equal to one quarter of the wavelength of the wave emitted by the generator (3) and circulating in the medium in which said circular plate (21, 23) and the skirt lie.

8. The device as claimed in any one of claims 1 to 7, **characterized in that** the short-circuit (19) is provided in an annular space between a cylindrical element (27) and the injection tube (13).

9. The device as claimed in claim 8, **characterized in that** the end of the cylindrical element (27) bears in a sealed manner on the mouth (18) of the container (10).

10. The device as claimed in any one of claims 1 to 9, **characterized in that** it includes high-voltage signal generator means (28) that are coupled to the injection tube (13) and are adapted for sending a high-voltage sinusoidal signal on the injection tube (13).

11. The device as claimed in preceding claim 10, **characterized in that** the high-voltage sinusoidal signal has a voltage between 500 and 3000 V.

12. The device as claimed in either of preceding claims 10 and 11, **characterized in that** said high-voltage sinusoidal signal consists of a plurality of cycles of damped sinusoidal signals.

13. The device as claimed in any one of preceding claims 10 to 12, **characterized in that** the carrier frequency of said signal is between 1 and 50 kHz.

14. The device as claimed in any one of claims 12 or 13, **characterized in that** the envelope frequency of said signal is between 100 and 10000 Hz.

15. The device as claimed in preceding claim 14, **characterized in that** said envelope frequency is between 500 and 2000 Hz.

16. The device as claimed in any one of claims 12 to 15, **characterized in that** the peak value of the high-voltage signal at the end of one of said cycles is damped to between 0 and 60% of the peak value of the first peak of this cycle.

17. The device as claimed in preceding claim 16, **characterized in that** the peak value of the high-voltage signal at the end of one of said cycles is damped to between 20 and 40% of the peak value of the first peak of this cycle.

18. The device as claimed in any one of claims 1 to 17, **characterized in that** the diameter of the circular plate (21, 23, 25, 26) is at least more than twice the diameter of the injection tube (13).

19. The device as claimed in any one of claims 1 to 18, **characterized in that** a second circular plate (26) is fixed radially to the injection tube (13) upstream of the circular plate (25).

20. The device as claimed in preceding claim 19, **characterized in that** the distance between the circular plate (25) and said second circular plate corresponds to a multiple of the half-wavelength of the electromagnetic wave generated by said generator (3).

## Patentansprüche

1. Vorrichtung zum Aufbringen einer Beschichtung auf einer Innenseite eines Behälters (10) aus Thermoplastmaterial des Typs, bei dem das Aufbringen mit Hilfe eines Plasmas mit Niederdruck, das im Inneren des Behälters (10) durch Erregen eines Vorläufergases dank elektromagnetischer Wellen des Typs UHF-Mikrowellen geschaffen wird, ausgeführt wird, und des Typs, bei dem der Behälter (10) in einen Hohlraum (2) aus leitendem Material gestellt wird, in dessen Inneres die Mikrowellen eingeführt werden, wobei die Vorrichtung Folgendes aufweist:
- einen Generator (3) elektromagnetischer UHF-Wellen;
- einen Wellenleiter (4) für elektromagnetische Wellen zum Anschließen des Generators (3) an ein Fenster (5) der Seitenwand des Hohlraums (2), der es erlaubt, mindestens ein zentrales Feld in dem Hohlraum (2) zu erzeugen;
- Mittel zum Einspritzen des Vorläufergases, die eine Einspritzröhre (13) aufweisen, die sich teilweise in den Behälter (10) erstreckt;
- Mittel zum Abpumpen des Hohlraums (2) und des Innenvolumens des Behälters (10), und
- einen Innenmantel (6), der zu dem Hohlraum (2) koaxial ist, der im Wesentlichen für elektromagnetische Wellen transparent ist, der zum Beispiel aus Quarz hergestellt ist und einen Einschluss (7) definiert, in den der Behälter (10) beim Erregen des Vorläufergases gestellt wird,
**dadurch gekennzeichnet, dass** die Einspritzröhre (13) in den Behälter (10) mit einer Länge zwischen dem Viertel und der Hälfte der Gesamthöhe des betreffenden Behälters (10) zwischen dem Mündungsrand (18) und dem Boden (17) des Behälters (10) eintaucht, wobei die Länge der Einspritzröhre (13) eine Längsantenne (16) bildet, die die von dem Generator (3) erzeugte elektromagnetische UHF-Welle fangen kann, dass ein UHF-Kurzschluss (19) in Form einer Platte (21, 23, 25) auf der Einspritzröhre (13) derart vorgesehen ist, dass die Hohlraumseite der Platte (21, 23, 25) einen Punkt mit Amplitude gleich Null der elektromagnetischen Welle, die sich entlang der Einspritzröhre (13) ausbreitet, bildet, wobei die Länge zwischen dem Kurzschluss (19) und dem freien Ende (13a) der Einspritzröhre (13) einer ungeraden Zahl von Vierteln von Wellenlängen entspricht, um auf dem Niveau des freien Endes (13a) der Einspritzröhre (13) eine maximale Amplitude, das heißt einen Wellenbauch zu erzielen.

2. Vorrichtung nach Anspruch 1, **dadurch gekennzeichnet, dass** der Kurzschluss (19) eine kreisförmige radiale Platte (21, 23, 25, 26) ist, die in ihrer Mitte von der Einspritzröhre (13) durchquert wird.

3. Vorrichtung nach Anspruch 2, **dadurch gekennzeichnet, dass** eine ringförmige Schürze (22, 24), die zu der Einspritzröhre (13) koaxial und zu dem Hohlraum (2) gerichtet ist, auf der kreisförmigen, radialen Platte (21, 23) aufliegt.

4. Vorrichtung nach Anspruch 3, **dadurch gekennzeichnet, dass** die ringförmige Schürze (22, 24) auf dem Außenrand der Platte (21, 23) aufliegt.

5. Vorrichtung nach einem der Ansprüche 2 bis 4, **dadurch gekennzeichnet, dass** die kreisförmige Platte (21, 23) in einen dielektrischen Stopfen (20), der axial von der Einspritzröhre (13) durchquert wird, eingelassen ist.

6. Vorrichtung nach einem der Ansprüche 1 bis 3 und 5,
**dadurch gekennzeichnet, dass** die kreisförmige Platte (23) eine zentrale Öffnung (23a) mit einem Durchmesser aufweist, der größer ist als der Durchmesser der Einspritzröhre (13), und dass die ringförmige Schürze (22, 24) auf dem Innenrand der Platte (23) aufliegt.

7. Vorrichtung nach einem der Ansprüche 5 oder 6, **dadurch gekennzeichnet, dass** die Höhe der Innenseite der ringförmigen Schürze (22, 24) im Wesentlichen gleich dem Viertel der Wellenlänge der Welle, die von dem Generator (3) gesendet wird und in dem Milieu zirkuliert, in dem sich die kreisförmige Platte (21, 23) und die Schürze befinden, ist.

8. Vorrichtung nach einem der Ansprüche 1 bis 7, **dadurch gekennzeichnet, dass** der Kurzschluss (19) in einem Ringraum zwischen einem zylindrischen Element (27) und der Einspritzröhre (13) vorgesehen ist.

9. Vorrichtung nach Anspruch 8, **dadurch gekennzeichnet, dass** das Ende des zylindrischen Elements (27) dicht auf dem Mündungsrand (18) des Behälters (10) aufliegt.

10. Vorrichtung nach einem der Ansprüche 1 bis 9, **dadurch gekennzeichnet, dass** sie Mittel (28) zum Erzeugen eines Hochspannungssignals aufweist, die mit der Einspritzröhre (13) gekoppelt und in der Lage sind, ein sinusförmiges Hochspannungssignal auf die Einspritzröhre (13) zu senden.

11. Vorrichtung nach dem vorhergehenden Anspruch 10, **dadurch gekennzeichnet, dass** das sinusförmige Hochspannungssignal eine Spannung zwischen 500 und 3000 V hat.

12. Vorrichtung nach einem der vorhergehenden Ansprüche 10 oder 11, **dadurch gekennzeichnet, dass** das sinusförmige Hochspannungssignal aus mehreren Zyklen gedämpfter Sinussignale besteht.

13. Vorrichtung nach einem der vorhergehenden Ansprüche 10 bis 12, **dadurch gekennzeichnet, dass** die Trägerfrequenz des Signals zwischen 1 und 50 kHz liegt.

14. Vorrichtung nach einem der Ansprüche 12 oder 13, **dadurch gekennzeichnet, dass** die Hüllenfrequenz des Signals zwischen 100 und 10.000 Hz liegt.

15. Vorrichtung nach dem vorhergehenden Anspruch 14, **dadurch gekennzeichnet, dass** die Hüllenfrequenz zwischen 500 und 2.000 Hz liegt.

16. Vorrichtung nach einem der Ansprüche 12 bis 15, **dadurch gekennzeichnet, dass** der Spitzenwert des Hochspannungssignals am Ende eines der Zyklen zwischen 0 und 60 % des Spitzenwerts der ersten Spitze dieses Zyklus gedämpft ist.

17. Vorrichtung nach dem vorhergehenden Anspruch 16, **dadurch gekennzeichnet, dass** der Spitzenwert des Hochspannungssignals am Ende eines der Zyklen zwischen 20 und 40 % des Spitzenwerts der ersten Spitze dieses Zyklus gedämpft ist.

18. Vorrichtung nach einem der Ansprüche 1 bis 17, **dadurch gekennzeichnet, dass** der Durchmesser der kreisförmigen Platte (21, 23, 25, 26) zumindest größer ist als das Doppelte des Durchmessers der Einspritzröhre (13).

19. Vorrichtung nach einem der Ansprüche 1 bis 18, **dadurch gekennzeichnet, dass** eine zweite kreisförmige Platte (26) radial auf der Einspritzröhre (13) stromaufwärts der kreisförmigen Platte (25) befestigt ist.

20. Vorrichtung nach dem vorhergehenden Anspruch 19, **dadurch gekennzeichnet, dass** die Entfernung zwischen der kreisförmigen Platte (25) und der zweiten kreisförmigen Platte einem Mehrfachen der halben Wellenlänge der von dem Generator (3) erzeugten elektromagnetischen Welle entspricht.
